# EUROPEAN PATENT APPLICATION

(11) **EP 0 933 783 A2**
(43) Date of publication of application: **04.08.1999**
(21) Application number: 99300250.0
(22) Date of filing: 13.01.1999
(51) Int. Cl.: G11C 11/22, H01L 21/8247, H01L 27/115, G11C 5/06, G11C 11/24

(54) **Nonvolatile semiconductor storage device using ferroelectric films and its fabricating method.**

(30) Priority: 29.01.1998 JP 1629098
(71) Applicant: Sharp Kabushiki Kaisha, Osaka-shi, Osaka 545-8522 (JP)
(72) Inventor: Kinoshita, Takao, Osaka-shi, Osaka-fu (JP)
(74) Representative: Brown, Kenneth Richard

(57) **Abstract**

A selective transistor is formed on a silicon substrate (1). A lower electrode (5) comprising Ti film and Pt film, a SrBi₂Ta₂O₉ film, an upper electrode (7) comprising Pt film, and a TiO₂ film (9) having such a configuration as to cover the upper electrode (7) and the SrBi₂Ta₂O₉ film (6) are formed on an interlayer insulating film (4) formed on the silicon substrate including the selective transistor. The upper electrode (7) and a drain region (12b) of the selective transistor are electrically connected to each other by metal wiring (11) via contact holes formed on the upper electrode (7) and the drain of the selective transistor. According to the semiconductor storage device having the above construction, the TiO₂ film and the lower electrode can be patterned continuously in one process. Therefore, the number of processes involved can be reduced and a cost reduction can be achieved.

## Description

### BACKGROUND OF THE INVENTION

The present invention relates to a semiconductor storage device and its fabricating method and, in particular, to a nonvolatile semiconductor storage device using ferroelectric films and its fabricating method.

In recent years, there have been developed nonvolatile semiconductor storage devices in which a ferroelectric film having spontaneous polarization is used as a capacitor. Oxides such as BaTiO₃, Pb(Zr, Ti)O₃ and SrBi₂Ta₂O₉ are principally used as the ferroelectric material. When these oxide ferroelectric films are used as the capacitor, it has been established that the ferroelectric film reacts with silicon oxide used as an interlayer insulating film, incurring deterioration of the ferroelectric characteristics. For this reason, as described in Japanese Patent Laid-Open Publication HEI 8-335673, it has been practiced to use barrier metal against such reaction so as to suppress the reaction, thus preventing the characteristic deterioration.

However, the barrier metal (for example, TiO₂) against the reaction, when left outside the capacitor part, would cause disconnections within a contact hole in later processes of forming the contact hole and forming metal wiring. This makes it necessary to make a mask that covers only the capacitor, and to remove the barrier metal in the contact hole opening by using photolithography and dry etching techniques.

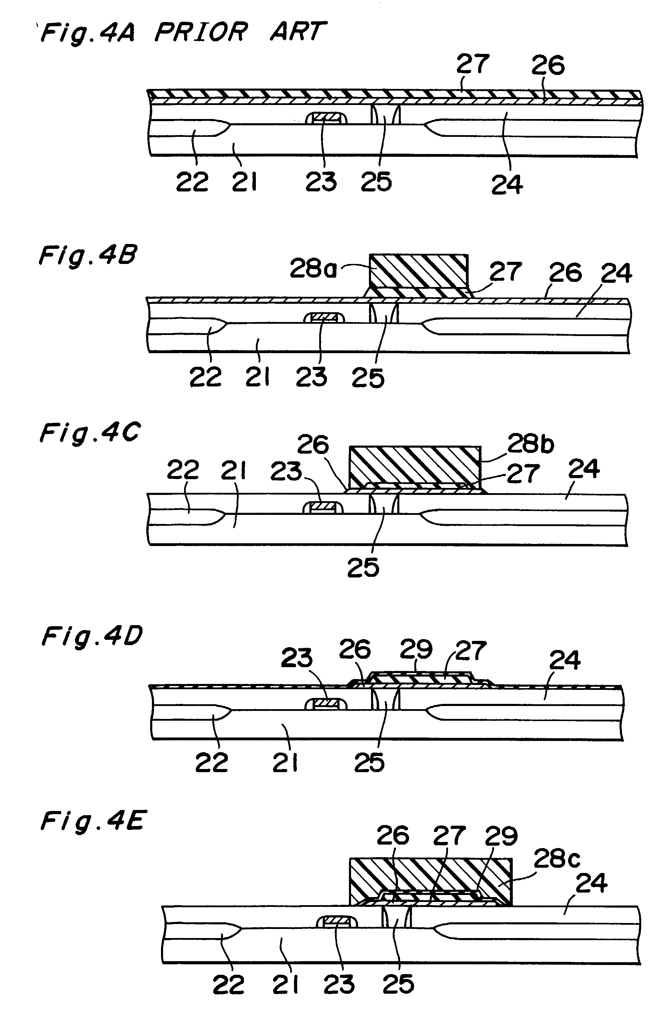

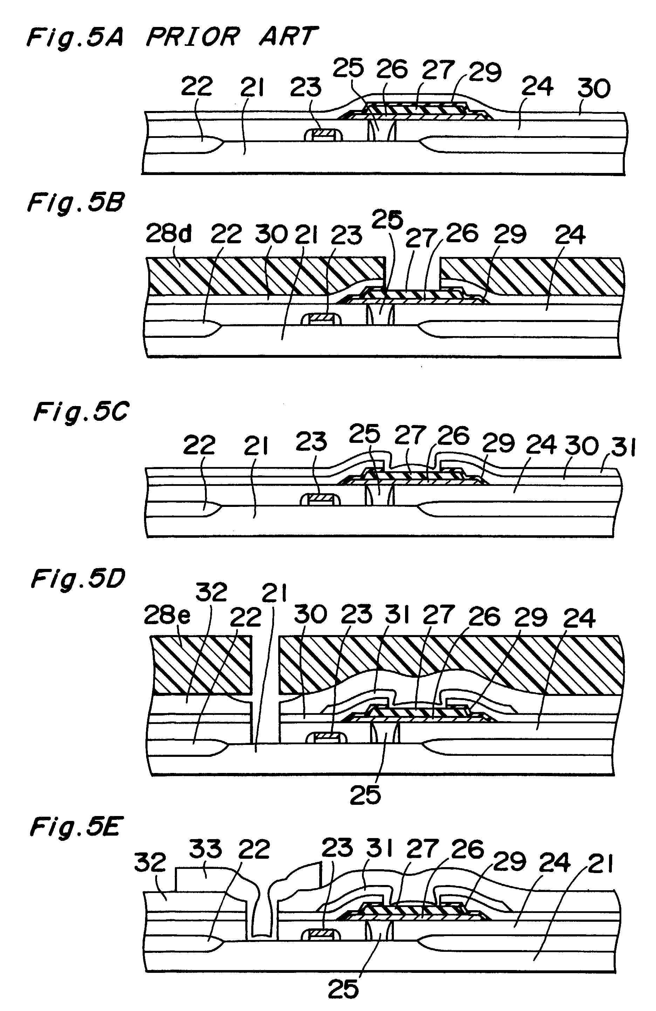

The fabricating process of the nonvolatile semiconductor storage device using a ferroelectric film for the capacitor according to the prior art is explained below with reference to Figs. 4 and 5. It is noted that in Figs. 4 and 5, reference numerals 28a, 28b, 28c, 28d, 28e denote photoresist.

First, a device isolating film 22 and a gate electrode 23 are formed on a silicon substrate 21 by known photolithography technique, dry etching technique, CVD technique or the like, and various types of ion injection are performed, by which a selective transistor is formed. After that, by known CVD process, silicon oxide 24 is deposited to 1000 nm, and flattened by known CMP process.

Next, a contact hole is formed by known photolithography technique and dry etching technique, and a polysilicon film is deposited by CVD process. After that, only the polysilicon is left within the contact hole by CMP process, and flattened, by which a polysilicon plug 25 is formed.

Next, a multi-layer film 26 of TiN/Ti film and Pt film is deposited on the polysilicon plug 25 by known sputtering process. In this case, because the TiN film is used as a barrier metal against the reaction of Pt and polysilicon, film thicknesses of Ti, TiN and Pt are 30 nm, 200 nm and 100 nm, respectively.

Next, for the formation of PZT(Pb(Zr, Ti)O₃) film, PZT sol-gel solution is spin coated on the Pt/TiN/Ti multilayer film 26, and heat treatment at 420°C for one hour is executed iteratively four times. After that, heat treatment at 660°C for 30 sec. is executed in N₂/O₂ atmosphere by RTA (Rapid Thermal Anneal) process (Fig. 4A). The final film thickness of the PZT film 27 in this case is about 200 nm.

Next, the PZT film 27 is processed by known photolithography technique and dry etching technique (Fig. 4B).

Next, the Pt/TiN/Ti multi-layer film 26 is processed also by known photolithography technique and dry etching technique, by which a lower electrode is formed (Fig. 4C). In this process, because film characteristics would be deteriorated by the plasma atmosphere of the etching, heat treatment is executed at temperatures of 500 - 600°C in N₂/O₂ atmosphere by RTA process. The conditions for etching the Pt film are a microwave power of 1000 W, a Cl₂ flow rate of 40 SCCM, a C₂F₆ flow rate of 40 SCCM, a CH₄ flow rate of 5 SCCM, an RF power of 150 W and a pressure of 1.4 × 10⁻³ Torr. The side wall deposit film deposited by the Pt film etching is removed by wet etching with HCl aqueous solution.

Further, after resist baking is carried out, TiN/Ti etching is performed under the following etching conditions. That is, the etching conditions are a microwave power of 1000 W, a Cl₂ flow rate of 90 SCCM, an RF power of 100 W and a pressure of 1.4 × 10⁻³ Torr.

Next, a TiO₂ film 29 is deposited to 50 nm by reactive sputtering process (Fig. 4D). After that, in order that this TiO₂ film 29 is not left in the contact hole opening in later process, the TiO₂ film in the contact hole opening is removed by known photolithography technique and dry etching technique (Fig. 4E). The conditions for removing TiO₂ film in this case are a microwave power of 1000 W, a Cl₂ flow rate of 25.5 SCCM, an Ar flow rate of 59.5 SCCM, an RF power of 100 W and a pressure of 1.4 × 10⁻³ Torr.

Next, as an interlayer insulating film, silicon oxide 30 is deposited to 150 nm by known CVD process (Fig. 5A).

Next, a Ti film is deposited to 10 nm by sputtering process so as to serve the function as a adhesion layer between Pt, which is used as an upper electrode, and the SiO₂ film, and then a contact hole for contact between the PZT film and the upper electrode is formed by known photolithography technique and dry etching technique (Fig. 5B). In this process, because ferroelectric film characteristics would be deteriorated by the plasma atmosphere of the etching process, heat treatment is executed at temperatures of 500 - 600°C by RTA process in N₂/O₂ atmosphere.

Next, a TiN/Pt film 31 is deposited by sputtering process, and an upper electrode to be used as a drive-in is formed by known photolithography technique and dry etching technique (Fig. 5C). In this process, because ferroelectric film characteristics would be deteriorated by the plasma atmosphere of the etching process, heat treatment is executed at temperatures of 500 - 600°C by RTA process in N₂/O₂ atmosphere.

Next, as an interlayer insulating film, silicon oxide 32 is deposited to 500 nm by known CVD process.

Finally, a contact hole is opened on the silicon substrate by known photolithography technique and dry etching technique (Fig. 5D), and then first-layer metal wiring is formed by sputtering process (Fig. 5E).

In the prior art, as shown in Figs. 4 and 5, a TiN film is provided in the lower electrode, by which the reaction of the Pt, which constitutes the lower electrode, and the polysilicon plug is prevented and besides the oxidation of polysilicon due to the permeation of oxygen or the like via Pt is prevented. However, to obtain the above effects, the film thickness of the TiN film needs to be at least 200 nm, resulting in lowered selection ratios (selectively) with resist, so that the etching process for the lower electrode (Pt/TiN/Ti) and the etching process for the barrier metal (TiO₂) need to be performed independently of each other. This would lead to cost increases due to increases in the number of processes involved.

### SUMMARY OF THE INVENTION

The object of the present invention is therefore to provide a semiconductor storage device and its fabricating method which eliminates need for the TiN film provided between the Pt film constituting the lower electrode and the Ti film, and enables the TiO₂ film and the lower electrode to be patterned continuously in one process, so that the number of processes involved can be reduced and a cost reduction can be achieved.

In order to achieve the above object, there is provided a semiconductor storage device in which a selective transistor is formed on a semiconductor substrate, and in which a lower electrode comprising Ti film and Pt film or Pt alloy film and serving as a drive-in, a ferroelectric film, an upper electrode comprising Pt film or Pt alloy film, and a TiO₂ film serving as a barrier metal having such a configuration as to cover the upper electrode and the ferroelectric film are formed on an interlayer insulating film formed on the semiconductor substrate including the selective transistor, wherein the upper electrode and a drain region of the selective transistor are electrically connected to each other by metal wiring via contact holes formed on the upper electrode and the drain region of the selective transistor.

Also, there is provided a method for fabricating a semiconductor storage device, comprising:
a step for, after forming a selective transistor on a silicon substrate, depositing one by one a Ti film, a first Pt film or Pt alloy film, a ferroelectric film and a second Pt film or Pt alloy film via an interlayer insulating film;
a step for patterning the second Pt film or Pt alloy film into a specified configuration, thereby forming an upper electrode, and then patterning the ferroelectric film into a specified configuration;
a step for, after depositing a TiO₂ film overall, patterning the TiO₂ film, the Pt film and the Ti film into a specified configuration, thereby forming a lower electrode serving as a drive-in and comprising the Pt film and the Ti film;
a step for, after forming an interlayer insulating film overall, forming contact holes on the upper electrode and a drain region of the selective transistor; and
a step for connecting the upper electrode and the drain region of the selective transistor to each other with metal wiring.

According to the above construction, which uses no polysilicon plug, eliminates the need for the TiN film which has conventionally been provided between the Pt film constituting the lower electrode and the Ti film for the suppression of reaction of the Pt conventionally serving as the lower electrode material and the polysilicon plug, as well as for the suppression of oxidation of the polysilicon plug due to the permeation of oxygen or the like via Pt. Thus, the problem of deterioration of the selection ratio of TiN film to resist is eliminated.

As a result, whereas the TiO₂ film for barrier metal and the lower electrode would conventionally be patterned in different processes because of the presence of the TiN film, the TiO₂ film and the lower electrode can be patterned continuously in one process in the present invention. Thus, the number of processes involved can be reduced by a reduction in the number of masks, so that a reduction in the number of particles and a cost reduction throughout all the processes can be achieved.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
Fig. 1 is a structural sectional view of a semiconductor storage device according to an embodiment of the present invention;
Fig. 2 is a fabricating process diagram of the first half for the semiconductor storage device according to the embodiment of the invention;
Fig. 3 is a fabricating process diagram of the second half for the semiconductor storage device according to the embodiment of the invention;
Fig. 4 is a fabricating process diagram of the first half for a semiconductor storage device having a ferroelectric capacitor according to the prior art;
Fig. 5 is a fabricating process diagram of the second half for the semiconductor storage device having a ferroelectric capacitor according to the prior art.

### DETAILED DESCRIPTION OF THE PREFERRED EMBODIMENTS

Hereinbelow, the present invention is described in detail based on an embodiment thereof.

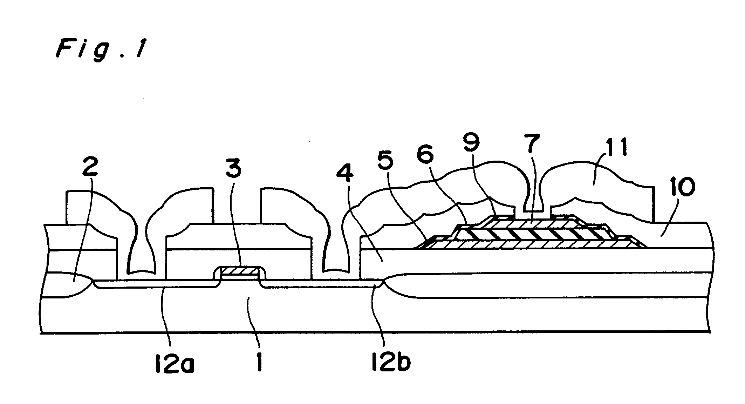

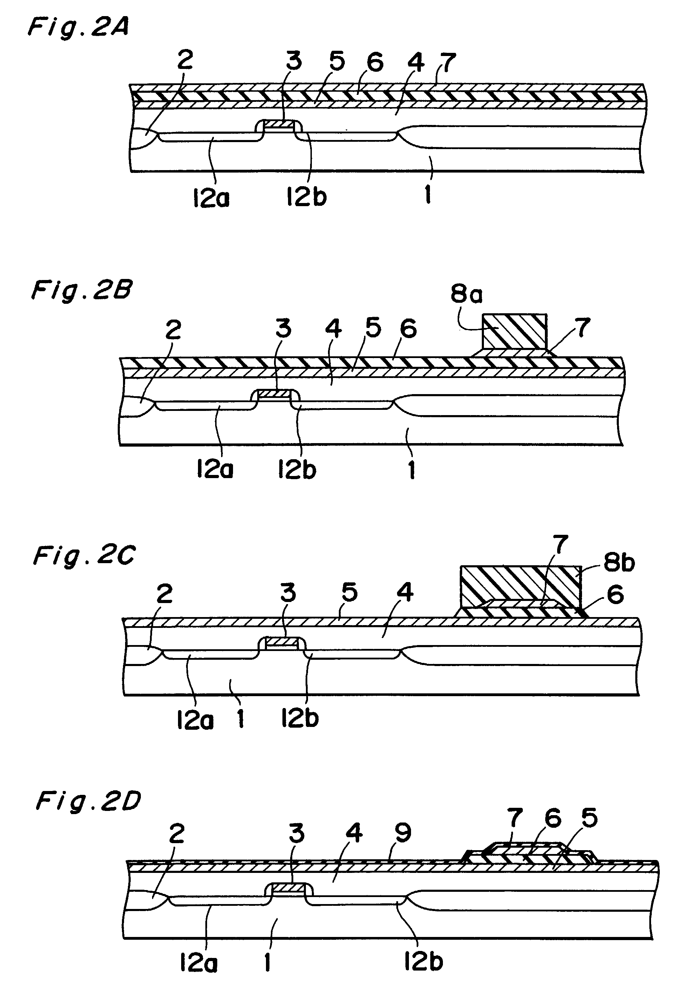

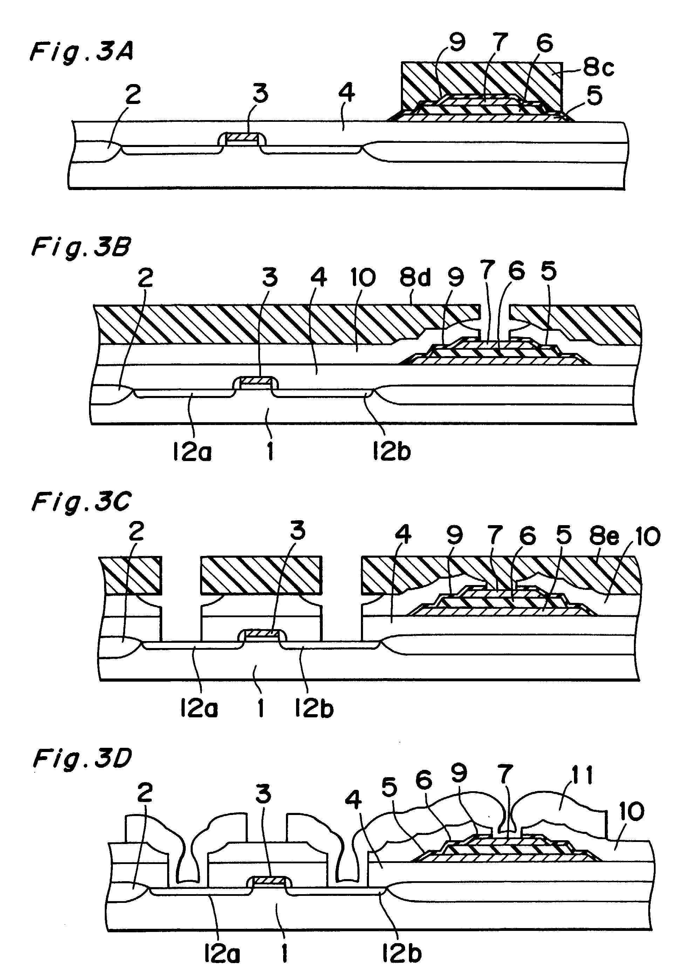

Fig. 1 is a structural sectional view of a semiconductor storage device according to an embodiment of the present invention. Fig. 2 is a fabricating process diagram of the first half for the semiconductor storage device according to the embodiment of the invention. Fig. 3 is a fabricating process diagram of the second half for the semiconductor storage device according to the embodiment of the invention. Referring to Figs. 1 to 3, reference numeral 1 denotes a silicon substrate, 2 denotes a device isolating film, 3 denotes a gate electrode, 4 and 10 each denote an interlayer insulating film, 5 denotes a Pt/Ti multilayer film, 6 denotes a SrBi₂Ta₂O₉ film, 7 denotes a Pt film, 8a, 8b, 8c, 8d and 8e denote photoresist, 9 denotes a TiO₂ film, 11 denotes metal wiring, 12a denotes the source region of a selective transistor, and 12b denotes the drain region of the selective transistor.

First, a device isolating film 2 and a gate electrode 3 are formed on a silicon substrate 1 by known photolithography technique, dry etching technique, CVD technique or the like, and various types of ion injection are performed, by which a selective transistor is formed. After that, by known CVD process, silicon oxide 4 is deposited to 1000 nm as an interlayer insulating film, and flattened by known CMP process. Then, a Pt/Ti multilayer film 5 comprising Ti film and Pt film is deposited by known sputtering process. In addition, in the present embodiment, the film thickness of the Ti film is 30 nm and the film thickness of the Pt film is 100 nm. Also, Pt alloy film may be used in place of the Pt film.

Next, for the formation of a SrBi₂Ta₂O₉ film 6, SrBi₂Ta₂O₉ sol-gel solution is spin coated on the Pt/Ti multilayer film 5, and baked on a 250°C hot plate. After that, heat treatment at 500°C for 5 min. and heat treatment at 800°C for 5 min. are executed in N₂/O₂ atmosphere iteratively four times by RTA process. The final film thickness of the SrBi₂Ta₂O₉ film 6 in this case is 150 nm.

Next, the Pt film 7 is deposited by sputtering process (Fig. 2A), and subsequently an upper electrode is formed by known photolithography technique and dry etching technique (Fig. 2B). It is noted that Pt alloy film may be used in place of the Pt film 7. After that, the SrBi₂Ta₂O₉ film 6 is crystallized and, for stabilization of its characteristics, heat treatment at 800°C for 30 min. is executed in N₂/O₂ atmosphere by using a diffusion furnace.

Next, the SrBi₂Ta₂O₉ film 6 is processed by known photolithography technique and dry etching technique (Fig. 2C), by which the capacitance of the ferroelectric memory is determined. And that, on the already processed upper electrode and ferroelectric film, the TiO₂ film 9 is deposited to 50 nm by reactive sputtering process as a barrier metal for suppressing the reaction of the silicon oxide and the SrBi₂Ta₂O₉ film (Fig. 2D) . In addition, reference numeral 8 denotes photoresist.

Next, the TiO₂ film 9 and the Pt/Ti multilayer film 5 are processed by known photolithography technique and dry etching technique, by which a lower electrode serving as a drive-in is formed (Fig. 3A). In the present invention, by the arrangement that the lower electrode is implemented by a Pt/Ti multilayer film, the lower electrode itself becomes a thin film and the problem as to the selection ratio with resist due to TiN is solved, thus allowing the etching of the lower electrode (Pt/Ti multilayer film) and the etching of the barrier metal (TiO₂ film) to be executed continuously in one process.

In this embodiment, the microwave power is 1000 W, the Cl₂ flow rate is 40 SCCM, the C₂F₆ flow rate is 40 SCCM, the CH₄ flow rate is 5 SCCM, the RF power is 150 W and the pressure is 1.4 × 10⁻³ Torr. Also, the side wall deposit film deposited by this etching is removed by wet etching with HCl aqueous solution.

Further, in this process, because the film characteristics would be deteriorated by the plasma atmosphere of the etching process, heat treatment is executed at temperatures of 500 - 600°C by RTA process in N₂/O₂ atmosphere.

Next, silicon oxide 10 is deposited as an interlayer insulating film to 500 nm by known CVD process, and subsequently a contact hole is opened on the capacitor by known photolithography technique and dry etching technique (Fig. 3B). In this process, because the film characteristics would be deteriorated by the plasma atmosphere of the etching process, heat treatment is executed at temperatures of 500 - 600°C by RTA process in N₂/O₂ atmosphere.

Finally, contact holes are opened on the source/dran regions 12a, 12b of the selective transistor formed on the silicon substrate by known photolithography technique and dry etching technique (Fig. 3C), and then metal wiring 11 is formed by sputtering process so that the upper electrode 7 and the drain region 12b are electrically connected to each other (Fig. 3D).

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A semiconductor storage device in which a selective transistor is formed on a semiconductor substrate (1), and in which a lower electrode comprising Ti film and Pt film or Pt alloy film and serving as a drive-in, a ferroelectric film (6), an upper electrode (7) comprising Pt film or Pt alloy film, and a TiO₂ film (9) serving as a barrier metal having such a configuration as to cover the upper electrode (7) and the ferroelectric film (6) are formed on an interlayer insulating film (4) formed on the semiconductor substrate (1) including the selective transistor, wherein the upper electrode (7) and a drain region (12b) of the selective transistor are electrically connected to each other by metal wiring (11) via contact holes formed on the upper electrode (7) and the drain region (12b) of the selective transistor.

2. A method for fabricating a semiconductor storage device, comprising:
a step for, after forming a selective transistor on a silicon substrate (1), depositing one by one a Ti film (5), a first Pt film (5) or Pt alloy film, a ferroelectric film (6) and a second Pt film (7) or Pt alloy film via an interlayer insulating film (4);
a step for patterning the second Pt film (7) or Pt alloy film into a specified configuration, thereby forming an upper electrode (7), and then patterning the ferroelectric film (6) into a specified configuration;
a step for, after depositing a TiO₂ film (9) overall, patterning the TiO₂ film (9), the Pt film (7) and the Ti film (5) into a specified configuration, thereby forming a lower electrode (5) serving as a drive-in and comprising the Pt film and the Ti film;
a step for, after forming an interlayer insulating film (10) overall, forming contact holes on the upper electrode (7) and a drain region (12b) of the selective transistor; and
a step for connecting the upper electrode (7) and the drain region (12b) of the selective transistor to each other with metal wiring (11).

3. A semiconductor storage device comprising a selection transistor formed in a semiconductor substrate and a capacitive storage element disposed on an interlayer insulating film formed on said substrate; wherein said storage element comprises a lower electrode serving as a drive-in, on the insulating film, a ferroelectric film on the lower electrode and an upper electrode on the ferroelectric film and wherein metal wiring is provided to electrically connect the upper electrode and a drain region of the transistor via contact holes formed respectively in a barrier film which covers the upper electrode and the ferroelectric film, and in the interlayer insulating film.

4. A device according to claim 3, including a further interlayer insulating film comprising silicon oxide formed over the transistor and the storage element, the contact holes extending through said further insulating film.

5. A device according to claim 3 or claim 4, wherein said lower electrode comprises Ti film, and Pt or Pt alloy film, wherein said upper electrode comprises Pt or Pt alloy film and wherein said barrier film comprises TiO_{2.}
